# EUROPEAN PATENT SPECIFICATION

(11) **EP 1 096 549 B1**
(45) Date of publication and mention of the grant of the patent: **02.01.2013**
(21) Application number: 00309403.4
(22) Date of filing: 25.10.2000
(51) Int. Cl.: H01L 21/687, C23C 14/50

(54) **Substrates support devices**
Haltevorrichtungen für Substrate
Supports pour substrats

(30) Priority: 29.10.1999 US 430724
(43) Date of publication of application: 02.05.2001
(73) Proprietor: Ferrotec (USA) Corporation, Bedford, NH 03110 (US)
(72) Inventor: Kroneberger, Cris Keith, Fairfield, California 94533 (US)
(74) Representative: von Hellfeld, Axel

(56) References cited:
- EP-A- 0 650 181
- JP-A- 62 165 946
- US-A- 4 306 731
- US-A- 5 253 411
- US-A- 5 820 684

## Description

This invention generally relates to support structures for restraining substrates, such as semiconductor wafers, during processing. More particularly, the invention relates to a compound spring assembly which can be easily manipulated by an operator with forces which exceed the strength of the substrate while imparting forces for restraining the substrate without damage.

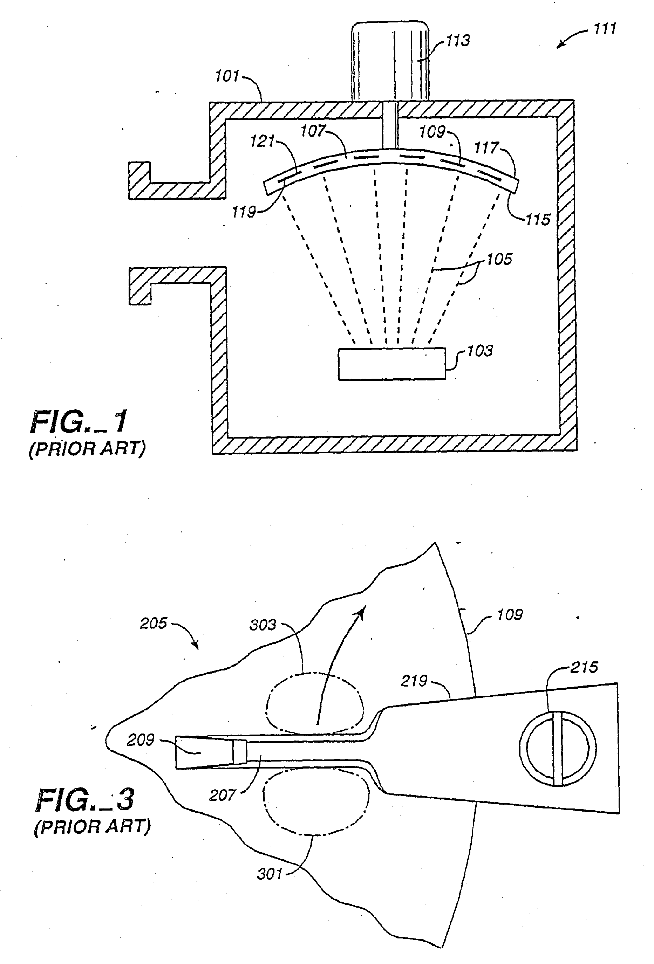

The deposition, or coating, of materials is a process widely used in the manufacturing of many semiconductor and optical components. An example of a batch processor 111 that can perform this type of process is shown schematically in Figure 1. The batch processor 111 includes a vacuum chamber 101, an evaporative source 103 of coating material 105, and a framework 107 generally positioned uniformly to coat a plurality of optical components, flat panel display panels, semiconductor wafers or other substrates 109 that are usually located approximately equidistant from the source 103. Using an evaporative source, coating materials may include many metals, semiconductors and refractory materials. The vacuum chamber 101 is opened, and the substrates 109 are manually loaded on to the framework 107 one at a time. The number of substrates that can be held by a framework varies with the substrate, chamber and framework size, with frameworks typically adapted to hold substrates of 25 mm to 200 mm in diameter or larger. The framework 107 is connected to a motor 113, rotating the framework within the chamber to increase the uniformity of the coating material 105 being deposited. Other systems, not shown, may have fixed frameworks, while others may incorporate multiple frameworks and planetary or other rotational systems for moving substrates about to produce a specific coating effect.

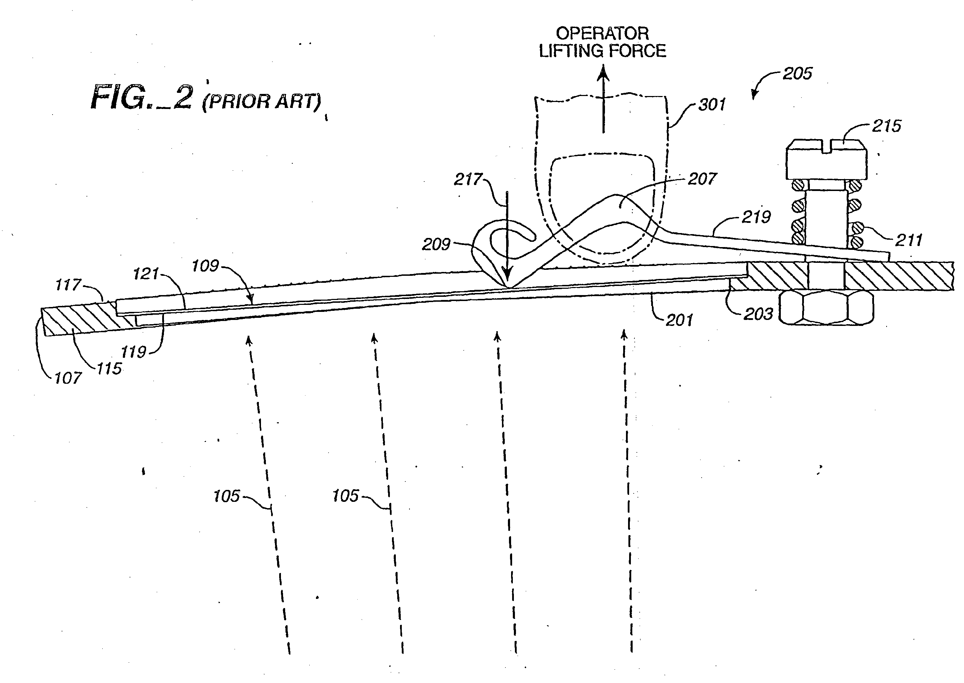

At the low pressures under which evaporative coating operations occur, typically 0,133 mPa to 0,0133 mPa (10⁻⁶ to 10⁻⁷ Torr), the material 105 travels in a straight line from the source 103, coating surfaces with a direct line-of-sight to the source. In the configuration of Figure 1, a framework front side 115 and a substrate front side 119 both face the source 103 and are coated, while a framework back side 117 and a substrate back side 121 face away from the source 103 and are generally not coated. Details of one of the many substrates which may be held in the prior art framework are shown in Figures 2 and 3. The substrate 109 is placed over one of the apertures 201, which are located over much of the framework surface and have a shape roughly the same as the substrates they are meant to hold. The substrate 109 is supported on the substrate front side 119 by a plurality of aperture tabs or an aperture lip 203, which supports some or all of the edge of the substrate 109, and on the substrate back side 121 by a prior art clip mechanism 205. Some systems have more than one clip for each substrate, especially for larger substrates, with a 150 mm substrate typically having two to four clips holding it in place. A substrate restraining force 217 is transferred from a deflected coil spring 211 to a substrate contact point 209 by a clip 219, which is rigid and metallic. Typical prior art clips are made of alloys such as stainless steel or Inconel (trade mark), with a thickness and shape that allow them to be rigid. The clip 219 can be pulled away from the substrate 109 by pinching a clip handle 207 between a thumb 301 and a forefinger 303, and rotated clear of the aperture 201 about a pivot pin 215, as shown in Figure 3.

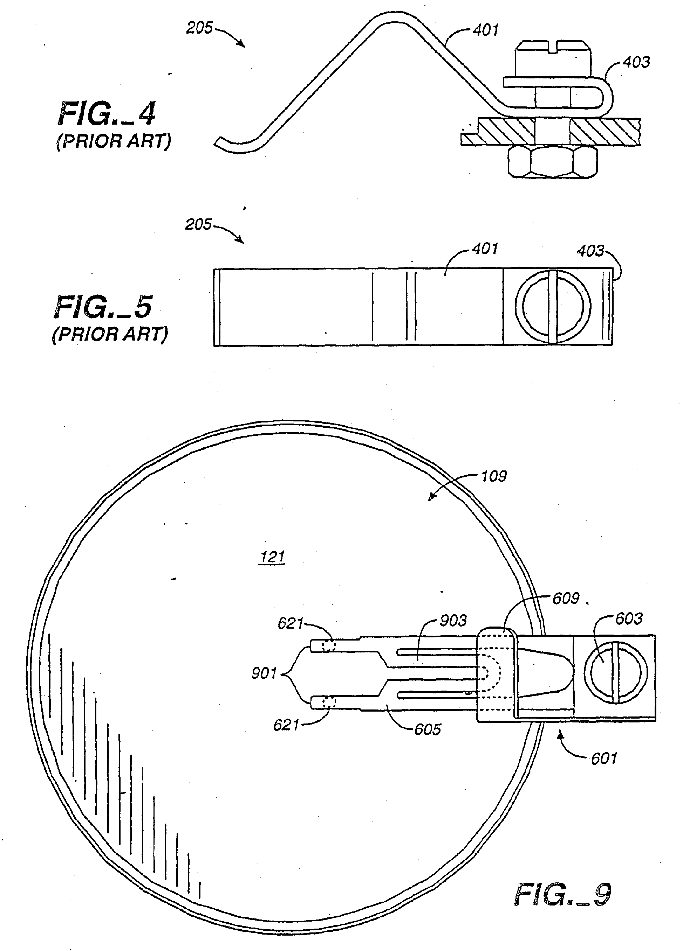

A second prior art clip mechanism 401 is shown in side and top view in Figures 4 and 5 respectively. In the clip mechanism 205, a combined clip spring 401 is made of a mildly flexible metal, producing less of a restraining force than the prior art clip mechanism 205. In addition, a coil spring 211 of the first prior art clip has been incorporated directly in to the clip through a bend 403. For this configuration, clip materials and shapes are chosen to allow some spring force to be imparted by the clip.

The first and second prior are clips of Figures 2 to 5 were designed primarily for substrates that can withstand the forces imparted by those clips, and the spring force acts both to restrain the clip and hold the substrate. These clips have wide utility, though not without problems, with silicon substrates. As galium-arsenide (Ga-As) substrates have become more common, several problems in using such prior art clips to restrain the more fragile Ga-As substrates have become evident, mainly due to their imparting a large force over a small substrate area. With the first prior art clip of Figures 2 and 3, the rigid clip 219 can rotate about the pivot pin 215 and is held in place by a stiff coil spring 211. However, this clip design has several drawbacks in that, as it is held in place against the substrate by a stiff spring, the force imparted by the clip has a limited lower value - it is difficult to design such a clip with a small force. If the operator accidentally releases a clip handle 207 before placing it on the substrate 109, the clip 219 is forced by the stiff spring 211 on to the substrate 109 and tending to damage more fragile substrate materials such as Ga-As.

Another drawback of this design is that since the stiff spring 211 also keeps the clip rigid, slight deformities due to mishandling the clip may result in a clip contact surface 209 smaller than the design area, with an increase in the substrate contact forces. Yet another drawback is that the clip handle 207 is close to the substrate back side 121, and thus the operator must be very careful not to touch the substrate. The second prior art clip of Figures 4 and 5 incorporates a less rigid, and slightly elastic material for a combined clip and stiff spring 403. This design is slightly better at maintaining a maximum contact surface with the substrate 109, but suffers from many of the same limitations as the first clip design.

The limitations of prior art clips used with fragile substrates can be partially addressed by the use of slotted restraining devices that hold the substrate by the application of forces primarily on the edge of the substrate. US Patent Specification No. 4,971,676 describes a framework in which a substrate is held in place by one edge spring and a plurality of edge abutments. Although this places less stress on a substrate once it is in place, other problems result from the sliding movement required in placing or removing the substrate.

For example, inserting the substrate in to the narrow slots defined by the edge abutments can result in breakage of fragile substrates. In addition the sliding required by that invention can scratch or create and deposit an unacceptable level of particulate matter on the substrate surface.

US5820684 describes a substrate support for an evaporation installation, having resilient clasps for holding substrates positioned against an inner surface of the support.

The present invention is concerned with the provision of a substrate support device or clip in which the substrate restraining force imparted by the clip is uncoupled from the force that holds the clip in place.

The clips of the invention also generally are able:
to impart restraining forces on a fragile substrate that will result in a lower incidence of substrate damage.
to ensure that forces used by the operator in positioning the present invention on a fragile substrate are not imparted on to the substrate.
to ensure that the forces used by the operator with the present invention provide positive and firm control while imparting a much smaller force on a substrate.
to ensure that the force imparted on to the substrate occurs over a larger contact area and at multiple points by the use of multiple leaves.
to ensure that the operator's fingers are kept way from the wafer during operation.
to ensure that the present invention be simple and inexpensive to manufacture and easy to use.

In accordance with the invention, there is provided a substrate support device as defined in claim 1.

For a better understanding of the invention, reference will now be made, by way of exemplification only, to the accompanying drawings, in which:
Figure 1, previously described, is a schematic of prior art vacuum deposition systems.
Figure 2, previously described, is a side view detail of a first prior art clip shown restraining a substrate.
Figure 3, previously described, is a top view of a first prior art clip.
Figure 4, previously described, is a side view of a second prior art clip.
Figure 5, previously described, is a top view of a second prior art clip.
Figure 6 is a side view of the first clip embodiment shown restraining a substrate of the invention.
Figure 7 is a end view of the first clip embodiment of Figure 6.
Figure 8 is a side view of the first clip embodiment of the invention showing the application of a lifting force by an operator.
Figure 9 is a top view of the first clip embodiment of the invention.
Figure 10 is a detail of the framework apparatus.
Figure 11 shows a flat pattern of the first clip embodiment of the invention before bending.
Figure 12 is a section view of the first clip embodiment of the invention through one prong.
Figure 13 is a top view of a second clip embodiment of the invention.
Figure 14 is a side view of the second clip embodiment showing lifting motion. Figure 15 is an end view of the second clip embodiment
Figure 16 is a top view of a third clip embodiment of the invention.
Figure 17 is a side view of the third clip embodiment of Figure 16.
Figure 18 is an end view of the third clip embodiment.
Figure 19 shows a first alternative multiple prong design in accordance with the invention.
Figure 20 shows a second alternative multiple prong design in accordance with the invention.
Figure 21 shows a third alternative multiple prong design in accordance with the invention.

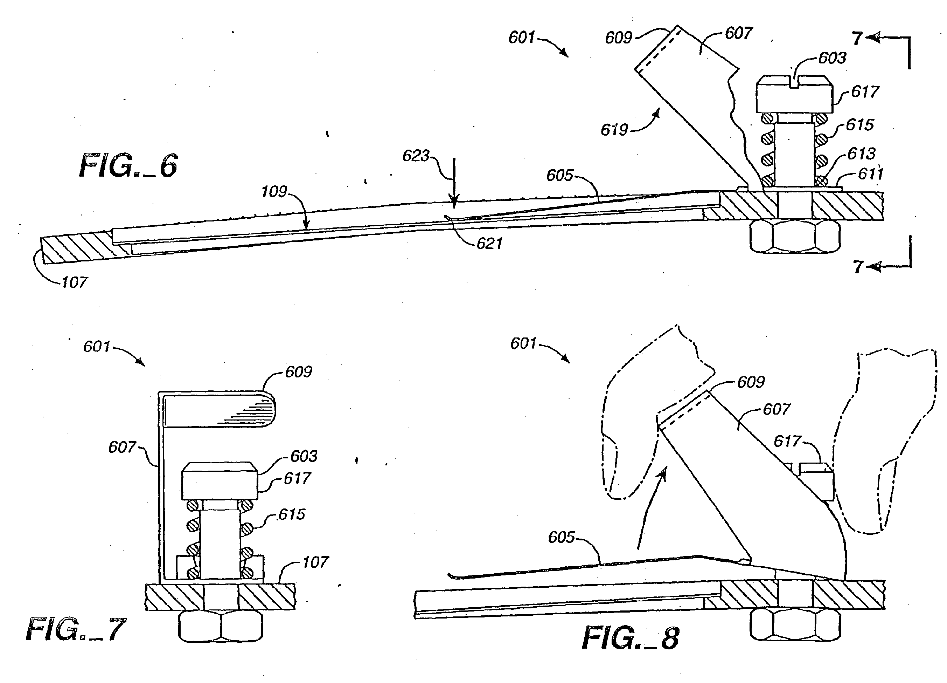

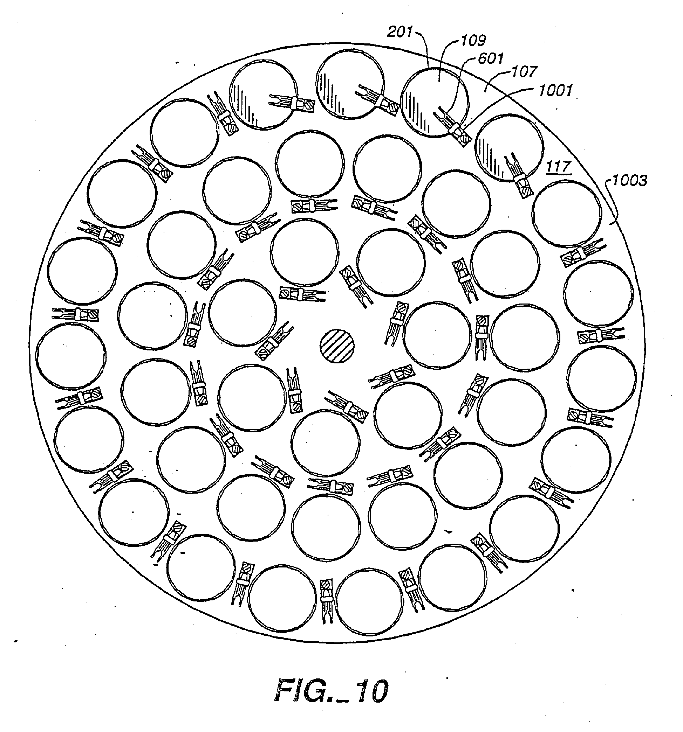

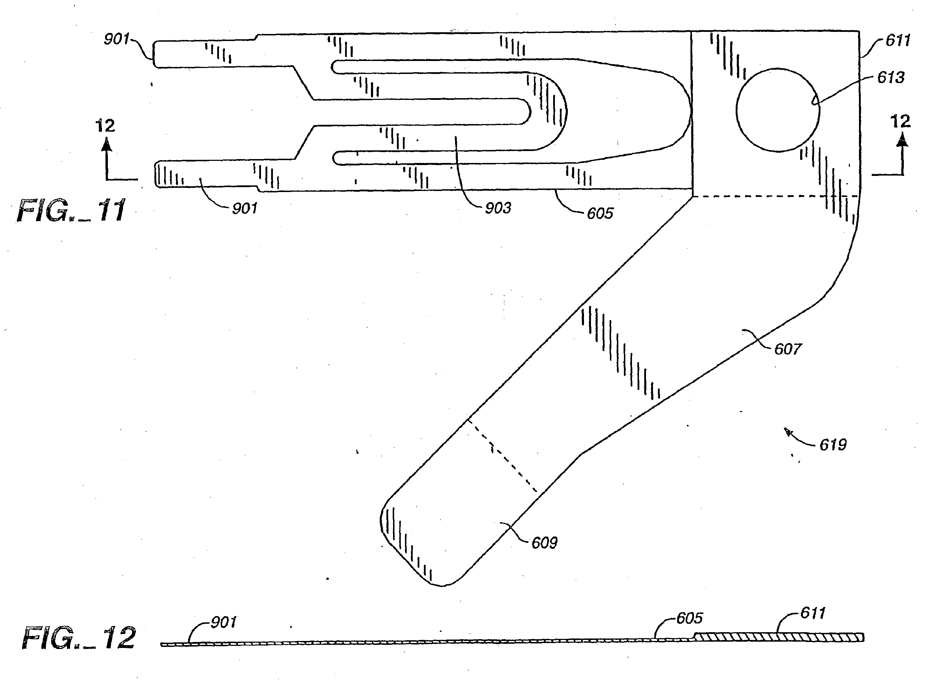

With reference to the drawings of the invention, Figures 6 to 12 show a first embodiment of the invention. The figures include static and moving side views (Figures 6 and 8), an end view (Figure 7), two top views (Figures 9 and 10), and clip pattern drawings (Figures 11 and 12). As shown in Figures 6 to 9, the first clip embodiment has a compound spring clip assembly 601 that includes a combined spring clip and a lever arm 619 that can rotate about a pivot pin 603. Components of the spring and the lever 619 include a leaf spring 605 and a lever arm 607 with a clip handle 609, and a clip supporting member 611 that has a pivot hole 613 through which the pivot pin 603 passes. The supporting member 611 and the pivot hole 613 are more clearly seen on the clip assembly drawing, Figure 11. Also part of the spring clip assembly 601, a second coil or other separate spring 615 is held under compression between a pivot pin end 617 and the supporting member 611 to the force clip 601 on to a framework 107.

The clip of the compound spring assembly has one or more spring elements providing the substrate restraining force and another, stiffer element providing the higher forces necessary to restrain the clip and for human manipulation of the clip. Figure 6 shows the clip positioned to restrain a substrate. In this position the spring and a lever 619 are held firmly in place by the clip assembly holding force provided by a coil spring 615. A substrate restraining force 623 near the end of the cantilevered end of the leaf spring or springs 605 results only from the bending action of the leaf spring 605 and is spread out over a contact area 621. The coil spring 615 provides a clip assembly holding force to keep the restrained end of the leaf spring 605 in place. Uncoupling of the substrate restraining force from the clip assembly holding force is provided by having a clip supporting member that is held in place by the coil spring against the action of the leaf spring, and by having a coil spring force that is greater than the leaf spring force, such that the spring constant of the coil spring is at least three times the spring constant of the leaf spring.

Figure 8 shows the clip raised for removal or placement of the substrate in the framework. The operator has pulled the handle 609 towards a pivot pin end 617 against the action of the coil spring 615. The coil spring 615 is chosen to have a restraining force chosen for easy and positive manipulation by the operator, and is entirely uncoupled from the substrate restraining force 623. The forces imparted on the substrate by the clip of the invention is less than 0.196 N (20g force), preferably in the range of 0.029N (3g force) to 0.049N (5g force). In addition to uncoupling the spring forces, this configuration has the added benefit of limiting possible damage from operator error. It has been shown that for even very fragile Ga-As substrates, releasing the handle from a raised position will not transfer enough force to the substrate to damage it. Likewise, if the operator inadvertently pushes the handle 609 towards the substrate 109 with enough force to overcome the force of the spring 615, only the relatively light force of the leaf spring 605 will be transmitted to the substrate, limiting the possibility of substrate damage from the clip. Another aspect of this clip is that the handle is placed far from the substrate to reduce the likelihood of an operator inadvertently touching the wafer.

Further details of leaf spring 605 are shown in Figure 9 top view. The leaf spring has two spring leaves 901 that are loosely coupled through a cross bar 903. The clip of the invention is not limited to the leaf configuration of the first clip embodiment, and other embodiments with multiple leafs and cross bars will be discussed subsequently. The spreading out of contact force is an important aspect of this invention. In contrast, prior art clips have a point, or at best a small line of contact, resulting in large, localised forces on the substrate. The leaf spring spreads out the substrate restraining force over a larger area, thus reducing the maximum localised stress within the substrate and minimise the chances for substrate damage. Because of the multiple leaves 901, the restraining force from the leaf 605 is shared between the pair of substrate contact areas 621, reducing the maximum substrate contact stress. The flexibility of the leaves 901 allows the leaves to bend in response to contact with the substrate 109, providing a larger contact area than is possible using rigid, prior art materials. Substrate restraining force 623 can be tailored to very low values, down to several grams force, by altering the thickness, shape and material of the leaf spring 605. Additional control of the force on the substrate 109 is affected by the curvature in the leaf spring 605 near the substrate contact area 621. The purpose of a cross bar 903 is to provide some linkage between the leaves 901 so that they move to limit damage to the leaf spring 605 in the event that one of the leaves 901 is accidentally deformed by the operator.

Figure 10 shows a view of the back side 117 of the framework 107. Each aperture 201 is associated with at least one clip assembly 601, with more clips used for larger substrates and apertures. Also shown in Figure 10 is the range of movement of the clip assembly 601 from an aperture clear position 1003 to a substrate restraining position 1001. The aperture clear position 1003 is representative of the position of the clip 601 when there is no substrate in its corresponding aperture, while the substrate restraining position 1001 shows the placement of the clip 601 for holding the substrate 109 against the framework 107. In moving the clip between positions, the clip 601 is grasped by the operator, providing the force to lift and rotate the clip. The lifting of the clip 601 is shown in Figure 8. A lifting force on the clip 601 is generated by pinching the clip as shown in Figure 8, or by grasping the handle 609 between thumb and forefinger and pulling in the direction shown. The clip is then rotated about the pivot pin 603 between the positions 1001 and 1003 by applying a slight sideways force to the end of the lever arm 609.

Further detail of spring and lever 619 is presented in Figures 11 and 12 which show the plan view, before being bent in to shape, of the sheet which will form the clip. The spring and lever 619 is formed from one piece of material by bending the sheet along the dashed lines in Figure 11 to form the shape shown in Figures 6 to 9. Clip materials are chosen to be suitable for forming both a leaf spring and a rigid portion, and may be stainless steel, Inconel (trade mark) or other suitable spring materials, with 17-7ph stainless steel being preferred. The leaf spring thickness depends on the spring material and shape as well as the required restraining force. A thickness of 50 to 254 microns (0.002 to 0.010 inch), with a preferred value of 100 microns (0.004 inch), will produce the low leaf spring force of the invention. The lever arm 607, the handle 609, and the supporting member 611 are preferably of a thickness and shape which allows for rigid manipulation by an operator under the force of spring 615. A thickness greater than 254 microns (0.010 inch) will generally produce the required rigidity, with 381 microns (0.015 inch) being the preferred value. The variation of thickness through spring and lever 619 as shown in Figure 12 is accomplished by photochemical milling, which is also used to form the details of the leaf spring 605. Other methods can also be used to manufacture the clip, including mechanical milling, shearing and stamping. The spring and lever 619 is then formed by bending the handle portion at the dotted lines indicated on Figure 12, and by bending the leaf spring 605 in to the shape shown on Figure 8, resulting in the final spring and lever shape.

Obvious variations of the above, some of which are discussed below, include incorporating the action of the coil spring in to the pivot connection of the clip, various taperings of the leaf spring to produce different substrate restraining forces, increasing the number of contact points and modifying the lever arm angle and length.

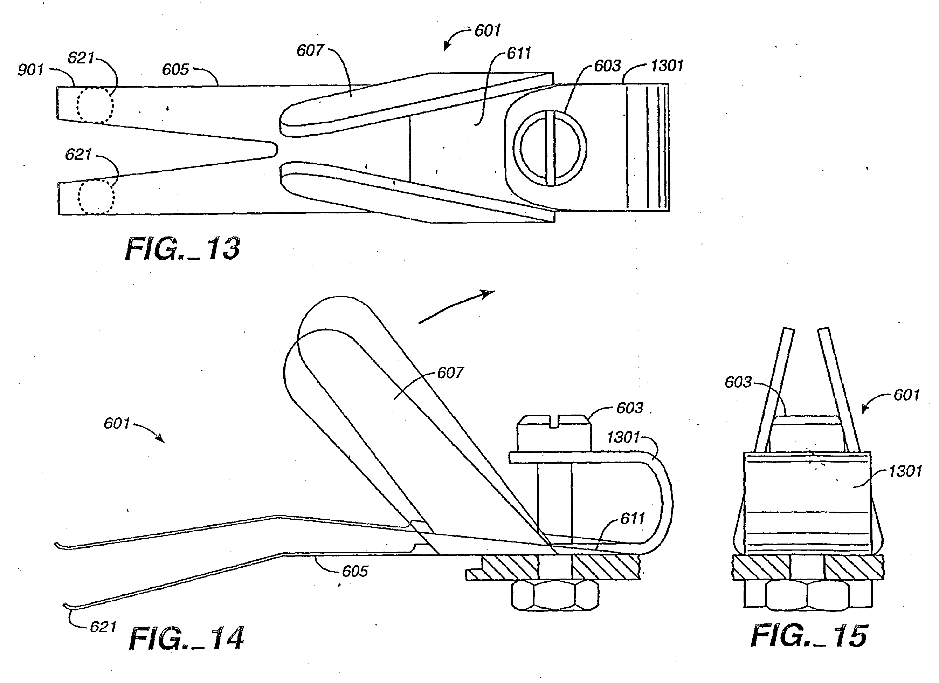

A second embodiment of the present invention is shown in Figures 13 to 15. This embodiment differs from the first embodiment in three basic ways. Firstly, the coil spring of the first embodiment is replaced with an integrated second spring 1301 formed as part of the supporting member 611. Eliminating the coil spring of the first embodiment results in a simpler clip assembly. While this simplifies the clip design and possibly reduces the cost, there is a smaller range of second spring constants than in the first embodiment, which has a separate spring. Secondly, the lever arm 607 comprises two portions that emanate from the supporting member 611, meeting near the same location as the clip handle 609 of the first embodiment. Thirdly, the spring leaves 901 are tapered as a method for producing the required leaf spring constant, and do not have the cross bar of the first embodiment.

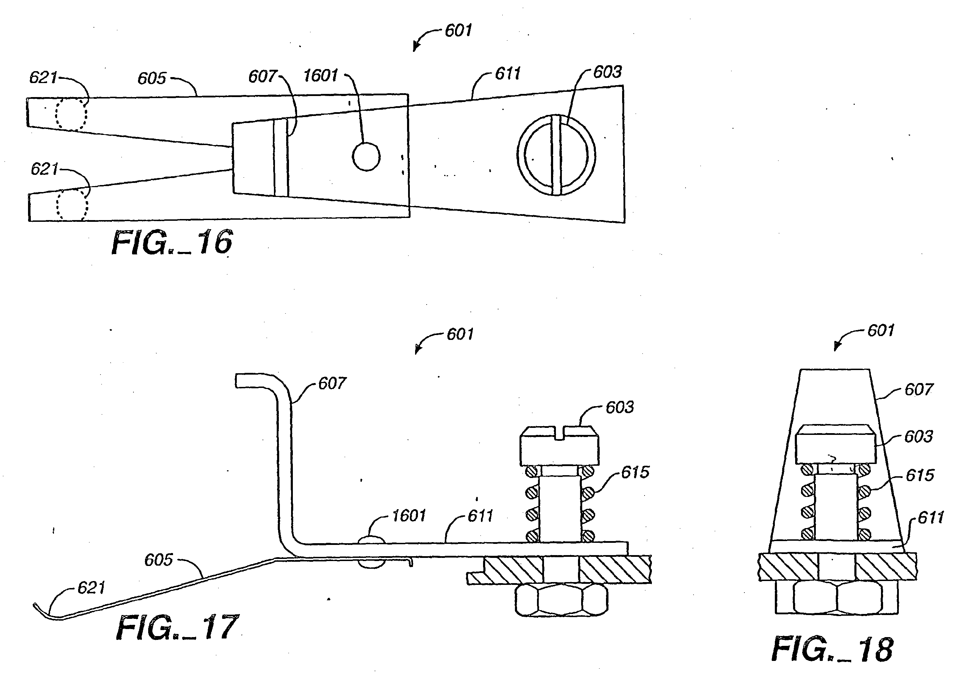

A third embodiment of the present invention, as shown in Figures 16 to 18, is bimetallic. The clip assembly comprises two connected materials chosen to perform the separate functions of providing the substrate restraining force and being the supporting member. The two materials and thicknesses are chosen for their mechanical properties, and so may range from being different materials and thicknesses to having some properties in common. Specifically, the leaf spring 605 is made of a material and with a thickness to provide the desired substrate restraining force. The lever arm 607 and supporting member 611 are of a material and thickness to provide the rigidity for manipulation and holding the leaf spring 605. A joint 1601 of the two materials is made using TIG, spot welding or any other joining method appropriate for the two materials. Appropriate materials for the leaf spring include 301 stainless steel and Inconel (trade mark), with 17-7ph stainless steel preferred, with thicknesses of 50 to 254 microns (0.002 to 0.010 inch). The lever arm and connecting member materials can be made from 301, 303, 304, 316 stainless steel or other materials compatible with the vacuum environment, with thicknesses of 254 to 1016 microns (0.010 to 0.040 inch).

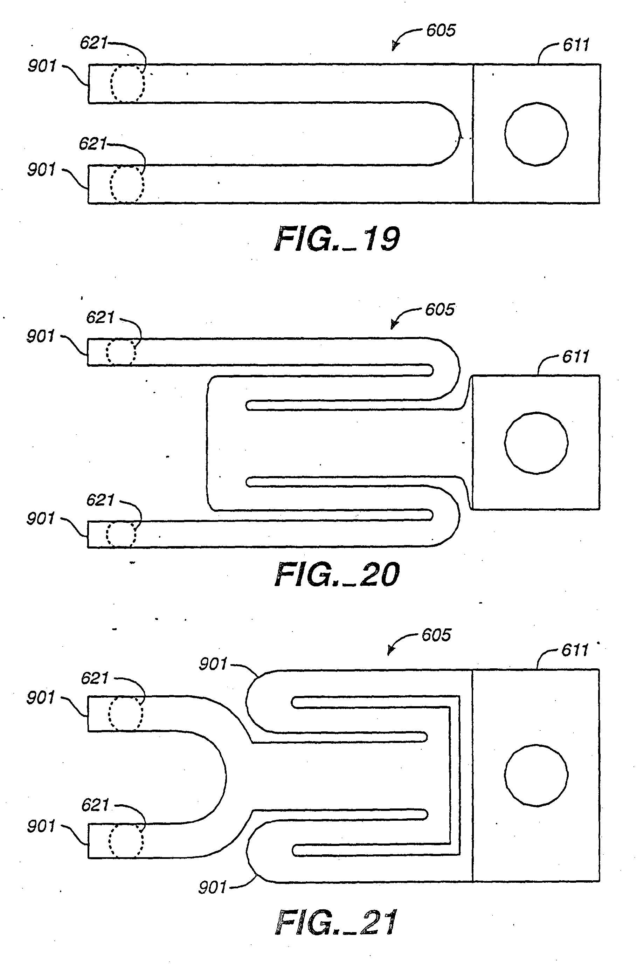

Several alternate leaf configurations are shown in Figures 19 to 20 and demonstrate a small number of the large variety and combination of spring leaves 901 and cross bars 903 possible. The choice of leaf spring design depends on the required total spring force, individual leaf force and placement of the force on the substrate. Figure 19 shows a leaf configuration similar to the second and third embodiments, in that there is no cross bar, but where spring leaves 901 are straight rather than tapered. Damage to the substrate is governed by the maximum pressure on the substrate, which is in term determined by the total substrate restraining force and the total contact area. The maximum pressure will be determined by the leaf spring constant, which is a function of the leaf thickness and width, and the distance that the spring is bent while holding the substrate. Variations in the leaf spring geometry can be used to control both the force and pressure on the substrate. Additional combinations of leaves and cross bars are shown in Figures 20 and 21, including a single leaf that bifurcates to two leaves in Figure 20, and a two leaf version that has a larger cross bar. Additional variations in leaf design, not shown, may include more than two leaves with more than two contact locations for spreading the substrate restraining force over a larger area.

## Claims

1. A substrate support device which comprises:
a framework (107) having a back side (117) and at least one through aperture (201), the aperture adapted to support the edge of a substrate positioned over the aperture from the framework back side;
**characterized by**,
a compound spring clip assembly (601) for providing a force to urge the substrate (621) against the framework including:
a leaf spring (605), having a leaf spring constant, with a restrained end and a cantilevered end, the leaf spring adapted to provide a substrate restraining force on a substrate in contact with the cantilevered end,
a lever arm (607) protruding away from the framework,
a clip supporting member (611) connecting the lever arm to the restrained end, and
a second spring (615) having a second spring constant at least three times greater than the leaf spring constant, the second spring providing a clip assembly holding force adapted to: restrain the clip supporting member against the framework against the force of the leaf spring, and provide resistance against which an operator must work for moving the assembly, whereby the operator can lift and place the clip against a substrate with a force controlled by the second spring, while the force against the substrate is controlled by the leaf spring.

2. A device according to Claim 1 in which the leaf spring comprises a plurality of spring leaves.

3. A device according to Claim 1 or Claim 2 in which the leaf spring includes one or more cross bars (903) interconnecting the spring leaves.

4. A device according to Claim 1 wherein the compound spring clip assembly is arranged to provide separate, uncoupled forces to both urge the substrate against the framework and hold the clip in place,
wherein the leaf spring comprises a plurality of leaf springs, having a leaf spring constant, providing a substrate restraining force,
and
the clip supporting member connects the lever arm to the leaf springs, and wherein the supporting member is adapted to be forced against the framework backside by the clip assembly.

5. A device according to any preceding claim in which the forces imparted on the substrate by the clip is less than 0.196 N.

6. A device according to any preceding claim in which the leaf spring, lever arm, and clip supporting member are formed from one piece of metal and in which the leaf spring thickness is from 50 to 254 microns and the lever arm and clip supporting element thickness is from 254 to 1016 microns.

7. A device according to any preceding claim in which the leaf spring, lever arm, and clip supporting member are formed from stainless steel.

8. A device according to any preceding claim in which:
the leaf spring consists of a first metallic piece,
the lever arm and supporting member consists of a second metallic piece, and
the clip assembly further includes a joint at which the first and second metallic pieces are fastened.

9. A device according to any preceding claim in which the second spring is formed by bending and restraining a portion of the clip supporting member.

10. A device according to any preceding claim in which the second spring is a coil spring.

11. A device according to any preceding claim in which the clip assembly includes:
a pivot pin with an axis perpendicular to the framework, and
a pivot pin hole in the clip supporting member for accommodating the pivot pin, such that the clip assembly can be rotated about the axis of the pivot pin, and the clip lifting force can be provided by the fingers of an operator placed on the pivot pin and the lever arm.

## Patentansprüche

1. Haltevorrichtung für Substrate, die aufweist:
einen Rahmen (107) mit einer Rückseite (117) und mindestens einer Durchgangsöffnung (201), wobei die Öffnung dazu eingerichtet ist, den Rand eines über der Öffnung von der Rahmenrückseite aus positionierten Substrats zu haltern;
**gekennzeichnet durch**
eine Verbund-Federbügelbaugruppe (601) zum Aufbringen einer Kraft, mit der das Substrat (621) gegen den Rahmen gedrückt wird, mit:
einer Blattfeder (605), die eine Blattfederkonstante hat, mit einem eingespannten und einem auskragenden Ende, wobei die Blattfeder dazu eingerichtet ist, eine Spannkraft auf das Substrat auszuüben, das mit dem auskragenden Ende in Kontakt steht,
einem Hebelarm (607), der aus dem Rahmen herausragt,
einem Bügellagerungselement (611) das den Hebelarm mit dem eingespannten Ende verbindet, und
einer zweiten Feder (615) mit einer zweiten Federkonstanten, die mindestens dreimal so groß ist wie die Blattfederkonstante, wobei die zweite Feder eine Bügelbaugruppen-Haltekraft bereitstellt, um das Bügellagerungselement gegen die Kraft der Blattfeder gegen den Rahmen zu halten, und einen Widerstand, den ein Bediener zum Bewegen der Baugruppe überwinden muss, so dass der Bediener den Bügel anheben und mit einer Kraft auf das Substrat aufsetzen kann, die von der zweiten Feder gesteuert wird, während die Kraft gegen das Substrat von der Blattfeder gesteuert wird.

2. Vorrichtung nach Anspruch 1, wobei die Blattfeder eine Mehrzahl Federblätter aufweist.

3. Vorrichtung nach Anspruch 1 oder 2, wobei die Blattfeder einen oder mehrere Querstäbe (903) aufweist, die die Federblätter miteinander verbinden.

4. Vorrichtung nach Anspruch 1, wobei die Verbund-Federbügelbaugruppe so ausgeführt ist, dass sie getrennte, nicht gekoppelte Kräfte bereitstellt, um sowohl das Substrat gegen den Rahmen zu drücken als auch den Bügel in seiner Position zu halten,
wobei die Blattfeder eine Mehrzahl Federblätter aufweist, eine Blattfederkonstante hat, die die Substrat-Haltekraft bereitstellt,
und
das Bügellagerungselement den Hebelarm mit den Blattfedern verbindet und wobei das Lagerungselement so ausgeführt ist, dass es von der Bügelbaugruppe gegen die Rahmenrückseite gedrückt wird.

5. Vorrichtung nach einem der vorigen Ansprüche, wobei die vom Bügel auf das Substrat ausgeübte Kraft geringer ist als 0,196 N.

6. Vorrichtung nach einem der vorigen Ansprüche, wobei die Blattfeder, der Hebelarm und das Bügellagerungselement aus einem Metallstück gebildet sind, und wobei die Dicke der Blattfeder zwischen 50 und 254 Mikron (µm) und die Dicke des Hebelarms sowie des Bügellagerungselements zwischen 254 und 1016 µm beträgt.

7. Vorrichtung nach einem der vorigen Ansprüche, wobei die Blattfeder, der Hebelarm und das Bügellagerungselement aus Edelstahl gebildet sind.

8. Vorrichtung nach einem der vorigen Ansprüche, wobei:
die Blattfeder aus einem ersten metallischen Stück besteht,
der Hebelarm und das Lagerungselement aus einem zweiten metallischen Stück bestehen, und
die Bügelbaugruppe ferner ein Gelenk enthält, an dem das erste und zweite metallische Stück befestigt sind.

9. Vorrichtung nach einem der vorigen Ansprüche, wobei die zweite Feder durch Biegen und Einspannen eines Abschnitts des Bügellagerungselements gebildet ist.

10. Vorrichtung nach einem der vorigen Ansprüche, wobei die zweite Feder eine Schraubenfeder ist.

11. Vorrichtung nach einem der vorigen Ansprüche, wobei die Bügelbaugruppe enthält:
einen Drehzapfen mit einer zum Rahmen senkrecht verlaufenden Achse, und eine Drehzapfenbohrung im Bügellagerungselement zur Aufnahme des Drehzapfens, so dass sich die Bügelbaugruppe um die Achse des Drehzapfens drehen kann, und die Kraft zum Anheben des Bügels von den Fingern des Bedieners aufgebracht werden kann, die auf den Drehzapfen und den Hebelarm gelegt werden.

## Revendications

1. Dispositif support de substrat qui comprend:
un cadre (107) ayant un côté de dos (117) et au moins une ouverture traversante (201), l'ouverture adaptée à supporter le bord d'un substrat positionné par-dessus l'ouverture à partir du côté de dos de cadre;
**caractérisé par**
un ensemble de pince à ressort combiné (601) pour créer une force pour pousser le substrat (621) contre le cadre incluant:
un ressort à lames (605), ayant une constante de ressort à lames, avec une extrémité maintenue et une extrémité en porte-à-faux, le ressort à lames adapté à créer une force de maintien de substrat sur un substrat en contact avec l'extrémité en porte-à-faux,
un bras de levier (607) en projection à l'écart du cadre,
un élément support de pince (611) connectant le bras de levier à l'extrémité maintenue, et
un deuxième ressort (615) ayant une constante de deuxième ressort au moins trois fois supérieure à la constante de ressort à lames, le deuxième ressort créant une force de maintien d'ensemble de pince adaptée à :
maintenir l'élément support de pince contre le cadre contre la force du ressort à lames, et créer une résistance contre laquelle un opérateur doit agir pour déplacer l'ensemble, d'où il résulte que l'opérateur peut soulever et mettre la pince en place contre un substrat avec une force contrôlée par le deuxième ressort, tandis que la force contre le substrat est contrôlée par le ressort à lames.

2. Dispositif selon la revendication 1, dans lequel le ressort à lames comprend une pluralité de lames de ressort.

3. Dispositif selon la revendication 1 ou la revendication 2, dans lequel le ressort à lames inclut une ou plusieurs entretoise(s) (903) interconnectant les lames de ressort.

4. Dispositif selon la revendication 1, dans lequel l'ensemble de pince à ressort combiné est agencé de façon à créer des forces séparées non couplées pour à la fois pousser le substrat contre le cadre et maintenir la pince en place,
dans lequel le ressort à lames comprend une pluralité de ressorts à lames, ayant une constante de ressort à lames, créant une force de maintien de substrat,
et
l'élément support de pince connecte le bras de levier aux ressorts à lames, et dans lequel l'élément support est adapté à être forcé contre le côté de dos de cadre par l'ensemble de pince.

5. Dispositif selon une quelconque revendication précédente, dans lequel les forces imparties sur le substrat par la pince sont inférieures à 0,196 N.

6. Dispositif selon une quelconque revendication précédente, dans lequel le ressort à lames, le bras de levier, et l'élément support de pince sont formés en une seule pièce de métal et dans lequel l'épaisseur de ressort à lames est de 50 à 254 micromètres et l'épaisseur de bras de levier et d'élément support de pince est de 254 à 1 016 micromètres.

7. Dispositif selon une quelconque revendication précédente, dans lequel le ressort à lames, le bras de levier, et l'élément support de pince sont formés en acier inoxydable.

8. Dispositif selon une quelconque revendication précédente, dans lequel:
le ressort à lames consiste en une première pièce métallique,
le bras de levier et l'élément support consistent en une deuxième pièce métallique, et
l'ensemble de pince inclut en outre une articulation au niveau de laquelle les première et deuxième pièces métalliques sont fixées.

9. Dispositif selon une quelconque revendication précédente, dans lequel le deuxième ressort est formé en courbant et en maintenant une partie de l'élément support de pince.

10. Dispositif selon une quelconque revendication précédente, dans lequel le deuxième ressort est un ressort hélicoïdal.

11. Dispositif selon une quelconque revendication précédente, dans lequel l'ensemble de pince inclut:
un tourillon avec un axe perpendiculaire au cadre, et
un trou pour tourillon dans l'élément support de pince pour recevoir le tourillon, de sorte que l'ensemble de pince peut être fait tourner autour de l'axe du tourillon, et la force de levage de pince peut être créée par les doigts d'un opérateur placés sur le tourillon et le bras de levier.
